# EUROPÄISCHE PATENTSCHRIFT

(11) **EP 1 585 702 B1**
(45) Veröffentlichungstag und Bekanntmachung des Hinweises auf die Patenterteilung: **05.07.2006**
(21) Anmeldenummer: 03756438.2
(22) Anmeldetag: 12.09.2003
(51) Int. Cl.: B81C 1/00

(54) **Verfahren zum Herstellen von isolationsstrukturen**
Method for producing insulation structures
Procédé pour produire des structures d'isolation

(30) Priorität: 13.09.2002 DE 10242661
(43) Veröffentlichungstag der Anmeldung: 19.10.2005
(73) Patentinhaber: Conti Temic microelectronic GmbH, 90411 Nürnberg (DE)
(72) Erfinder: AIKELE, Matthias, 81673 München (DE); ENGELHARDT, Albert, 81247 Müchen (DE); FREY, Marcus, 83233 Bernau (DE); HARTMANN, Bernhard, 81675 München (DE); SEIDEL, Helmut, 82319 Starnberg (DE)
(86) Internationale Anmeldenummer: PCT/DE2003/003049
(87) Internationale Veröffentlichungsnummer: WO 2004/026759

(56) Entgegenhaltungen:
- US-A- 5 041 898
- US-A- 5 747 377
- US-B1- 6 342 427
- CHUNBO ZHANG ET AL: "Fabrication of thick silicon dioxide layers using DRIE, oxidation and trench refill" IEEE, 2002, Seiten 160-163, XP010577620

## Beschreibung

Die Erfindung betrifft Verfahren zum Herstellen von Isolationsstrukturen für mikromechanischen Sensoren in einkristalliner Oberflächentechnologie.

Bei mikromechanischen Sensoren in einkristalliner Oberflächentechnologie besteht die Anforderung freigeätzte Strukturen, wie zum Beispiel Federelemente oder Teile eines Plattenkondensators, einerseits am Substrat mechanisch zu verankern und gleichzeitig elektrisch davon zu isolieren.

Aus der Druckschrift US 5,930,595 "Isolation process for surface micromachined sensors and actuators" ist ein Verfahren bekannt, bei dem durch tiefe Trenchgräben definierte Siliziumstrukturen geätzt und durch einen "Release-Etch" Schritt auch auf ihrer Unterseite zum Substrat hin freigelegt werden. Anschließendes Auffüllen dieser Gräben mit einem dielektrisch isolierenden Material, wie zum Beispiel Siliziumdioxid, führt zu einer festen Verankerung durch eine dreiseitige, einseitig offene Umklammerung der Siliziumstruktur mit den aufgefüllten Trenchgräben.

Dieses Verfahren weist jedoch eine Reihe von Nachteilen auf. Das aufgefüllte dielektrische Material im Trenchgraben weist in der Mittellinie eine Wachstumsfuge auf. Im Regelfall entstehen zusätzlich Hohlräume (Voids) im Innenbereich der Fuge. Diese Effekte führen zu mechanischen Instabilitäten und Zuverlässigkeitsproblemen.

Außerdem benötigt die Verankerungs- und Isolationsstruktur einen eigenen, relativ aufwendigen Ätzschritt zur Freilegung der Strukturunterseite zum Substrat hin, den sogenannten Release-Etch Schritt. Dieser Schritt wird bei der späteren Erzeugung der eigentlichen mechanischen Struktur nochmals benötigt, kommt also in der Prozessfolge doppelt vor.

Aus der US 6,239,473 B1 ist eine Isolationsstruktur für mikromechanische Anordnungen und ein Verfahren zur Herstellung derselben bekannt, bei dem zunächst ein tiefer Graben mit hohem Aspektverhältnis in ein Siliziumsubstrat geätzt und anschließend mit einem thermischen oder abgeschiedenen Siliziumoxid wieder aufgefüllt wird. Danach wird der so aufgefüllte Graben zusammen mit der Funktionsstruktur vollständig unterätzt, so dass die Funktionsstruktur im freigeätzten Teil eine vertikale, elektrische Isolierung gegen das Substrat aufweist. Auch hier ist ein großer Nachteil, dass beim Auffüllen des Grabens mit Siliziumdioxid in dessen Mitte eine Wachstumsfuge sowie Hohlräume entstehen, die zur Instabilität der Anordnung in nicht unerheblichen Maß beitragen.

Aus der US 5,041,898 ist eine Isolationsstruktur bekannt, bei der zunächst Gräben in ein Siliziumsubstrat geätzt und diese mit einem thermischen Siliziumoxid aufgefüllt werden. Danach wird eine Verbindungsstruktur aus Metall auf der Oxidschicht gebildet. Die Druckschrift US 5,747,377 beschreibt einen Isolationsbereich, der von oxidierten Tiefgräben gebildet wird und sich zwischen im Substrat liegenden Transistoren befindet.

Aufgabe der Erfindung ist es, diese Nachteile zu vermeiden und die freigeätzten Strukturen in platzsparender und zuverlässiger Weise am Substrat mechanisch zu verankern und gleichzeitig elektrisch davon zu isolieren.

Diese Aufgabe wird durch Verfahren mit den Merkmalen des Anspruchs 1 gelöst. Die Ausgestaltung der Erfindung erfolgt gemäß den Merkmalen der abhängigen Ansprüche.

Der wesentliche Gedanke der Erfindung ist es anstelle des Auffüllens von Gräben die Umwandlung von dünnwandigem Silizium in ein elektrisch nichtleitendes Material vorzunehmen. Dies kann zum Beispiel mit Hilfe einer thermischen Oxidation von schmalen, zuvor durch Trenchgräben freigelegten Siliziumstegen bewerkstelligt werden. In der Minimalkonfiguration müssen dazu zwei Trenchgräben (Löcher) pro Steg mit der gewünschten Strukturtiefe geätzt werden. Der dazwischenliegende Siliziumsteg muss schmal genug sein, um vollständig thermisch durchoxidiert werden zu können.

Bei dieser Oxidation wandelt sich das Silizium vollständig in Siliziumdioxid um und erfährt dabei in etwa eine Verdoppelung des Volumens.

Bei einer kontinuierlichen Anordnung von Trenchgräben und Zwischenräumen mit geeigneten Abständen kann eine durchgehende isolierende Oxidstruktur über längere Wegstrecken erzeugt werden.

Bei größeren Stegbreiten kann der Prozess der Oxidation auch mehrstufig ausgeführt werden, indem nach einem ersten Oxidationsschritt, das entstandene Siliziumdioxid erst durch einen Ätzschritt wieder entfernt wird und anschließend ein zweites Mal oxidiert wird. Dies verkürzt die Prozesszeiten, da das Wachstum des Oxides eine Wurzelfunktion der Zeit ist, d.h. bei größer werdenden Oxiddicken findet eine starke Verlangsamung statt.

Auf oben beschriebene Weise wird der Platzbedarf für die Isolationsstruktur sehr klein, so dass differentiell ausgelesene kapazitive Sensoren unmittelbar realisiert werden können. Ferner entstehen bei diesem Verfahren weder Wachstumsfugen noch Hohlräume (Voids), so dass die mechanische Verankerung der Funktionsstruktur in hoher und langzeitstabiler Qualität gewährleistet werden kann. Ein zeitlich aufwendiger Release-Etch Schritt ist nicht mehr notwendig, da die nachfolgende mechanische Struktur direkt am "Oxidpfeiler" verankert werden kann.

Die Erfindung ermöglicht wesentliche Verbesserungen in der Herstellung von mikromechanischen Sensoren in einer Oberflächentechnologie auf der Basis von einkristallinem Silizium. In dieser Technologie können vor allem Inertialsensoren für Beschleunigung und Drehrate hergestellt werden. Insbesondere dient die Erfindung der kostengünstigen Herstellung von Beschleunigungssensoren für die Airbag-Anwendung in Kraftfahrzeugen.

Die Erfindung wird nachfolgend anhand von Ausführungsbeispielen und Figuren näher erläutert. Kurze Beschreibung der Figuren:
- Figur 1: zeigt in einer Ansicht von oben einen Ausschnitt auf das Substrat nach der Herstellung eines Paars von Trenchgräben.
- Figur 2: zeigt die Anordnung der Figur 1 entlang der Schnittlinie 2-2 im Querschnitt.
- Figur 3: zeigt die Anordnung der Figur 1 nach dem Beginn des Prozessschritt der Oxidation des Siliziums im Trenchgrabenbereich.
- Figur 4: zeigt die Anordnung der Figur 3 entlang der Schnittlinie 4-4 im Querschnitt.
- Figur 5: zeigt die Anordnung der Figur 1 nach der vollständigen Oxidation des Siliziums zwischen den Trenchgräben.
- Figur 6: zeigt die Anordnung der Figur 5 entlang der Schnittlinie 6-6 im Querschnitt.
- Figur 7: zeigt die Anbindung einer Funktionsstruktur an die lsolationsstruktur.
- Figur 8: zeigt die Anordnung der Figur 7 entlang der Schnittlinie 8-8 im Querschnitt.
- Figur 9: zeigt die elektrische Kontaktierung einer Einzelstruktur durch eine über die Isolationsstruktur führende Leiterbahn.
- Figur 10: zeigt die platzsparende Anordnung einer differentiellen Kondensatorstruktur durch alternierende Kontaktierung der kapazitiven Finger.

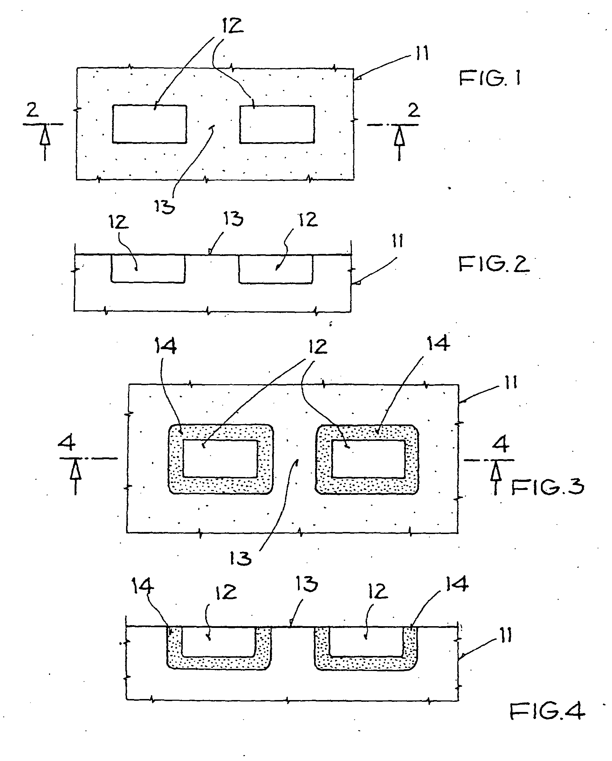

Ausgehend von einer Siliziumscheibe als Substratmaterial 1 werden zur Herstellung der Isolationsstrukturen für die Funktionsstrukturen 15 Trenchgräben 12 geätzt. Dabei sind mindestens zwei von ihnen so voneinander beabstandet angeordnet, dass ein Steg 13 aus Substratmaterial einer gewissen Breite dazwischen stehen bleibt. Der Siliziumsteg 13 muss schmal genug sein, um bei dem später folgenden Prozessschritt der thermischen Oxidation vollständig oxidiert zu werden. Idealerweise liegt die Breite des Steges in einem Bereich von kleiner 2µm. Zunächst wird mit Hilfe von photolithographischen Verfahren eine Ätzmaske definiert. Hierzu dient beispielsweise eine auf die Oberfläche der Substratscheibe aufgebrachte Schicht aus Siliziumdioxid, die mit Hilfe eine Photolackschicht entsprechend strukturiert wurde oder die Photolackschicht selbst. Dann werden mittels Trockenätzen die Trenchgräben 12 mit hohem Aspektverhältnis herausgeätzt. Die typische Tiefe der Trenchgräben 12 beträgt ca. 10 bis 30 µm. Wenn erforderlich wird zum Abschluss die Ätzmaske wieder entfernt. Die Figur 1 zeigt in einer Ansicht von oben einen Ausschnitt auf das Substrat nach der Herstellung eines Paars von Trenchgräben. Die Figur 2 zeigt die Anordnung der Figur 1 entlang der Schnittlinie 2-2 im Querschnitt.

Nun folgt die Umwandlung der Zwischenstege 13 in Siliziumdioxid 14 durch thermische Oxidation. Die Figur 3 zeigt die Anordnung der Figur 1 nach dem Beginn des Prozessschritt der Oxidation des Siliziums im Trenchgrabenbereich 14; die Figur 4 zeigt die Anordnung der Figur 3 entlang der Schnittlinie 4-4 im Querschnitt. Die thermische Oxidation erfolgt bei Prozessbedingungen mit typisch ca. 1100 - 1200 °C bei feuchten Umgebungsbedingungen (H₂O).

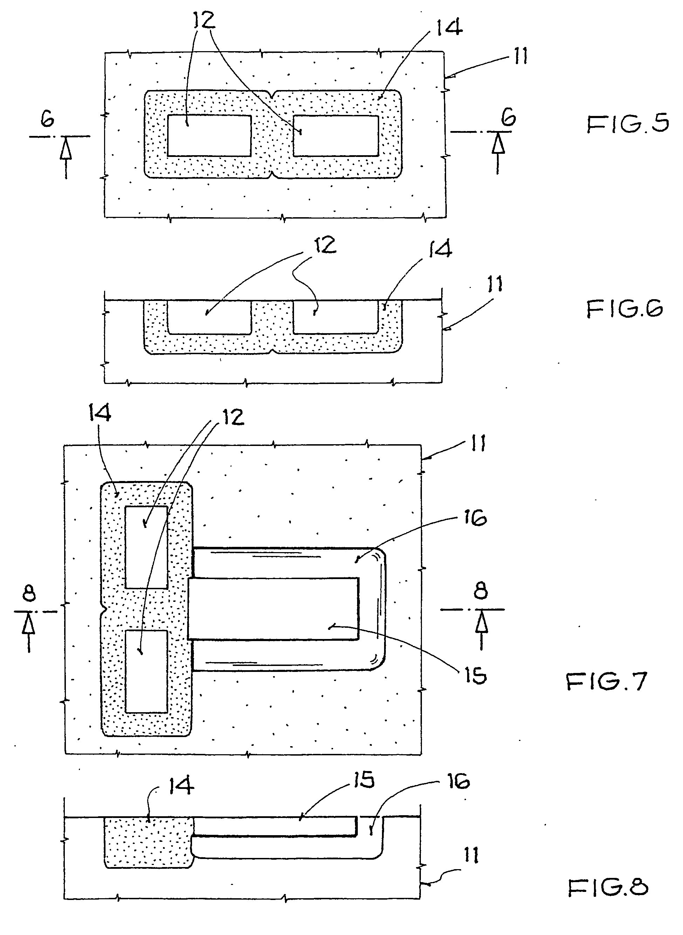

Bei größeren Breiten der Stege 13 kann der Prozess der Oxidation auch mehrstufig ausgeführt werden, indem nach einem ersten Oxidationsschritt, das entstandene Siliziumdioxid 14 durch einen Ätzschritt wieder entfernt wird. Anschließend wird ein zweites Mal oxidiert. Das Siliziumdioxid SiO₂ wird nass oder trocken entfernt. Die mehrstufige Oxidation verkürzt die Prozesszeiten, da das Wachstum des Oxides eine Wurzelfunktion der Zeit ist, d.h. bei größer werdenden Oxiddicken findet eine starke Verlangsamung der Oxidation statt. Die Figur 5 zeigt die Anordnung der Figur 1 nach der vollständigen Oxidation des Siliziums zwischen den Trenchgräben 12. Die Figur 6 zeigt die Anordnung der Figur 5 entlang der Schnittlinie 6-6 im Querschnitt.

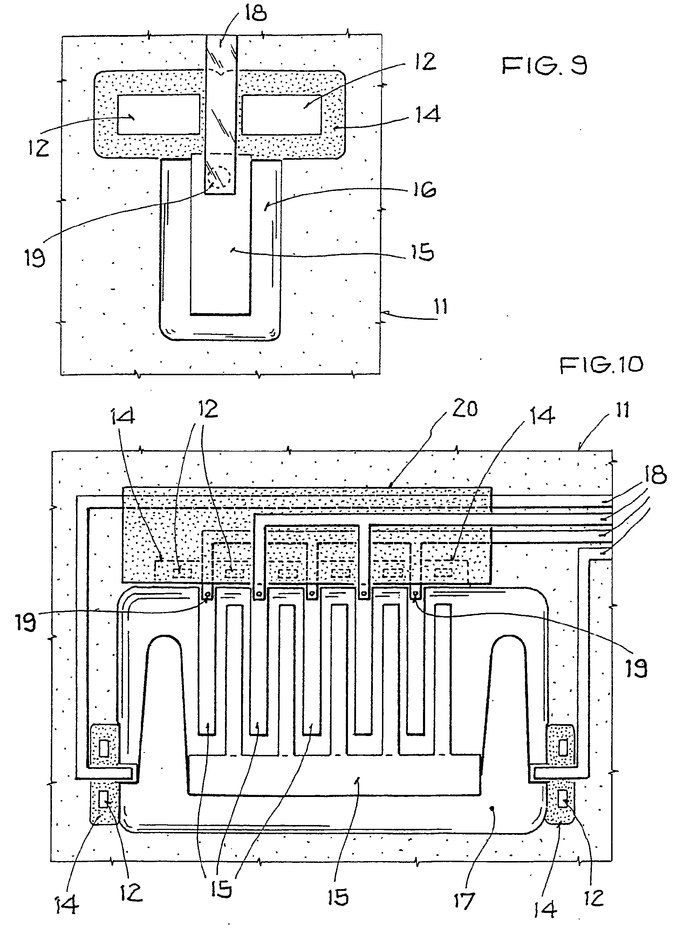

Es folgt die Herstellung der gewünschten mechanischen Funktionsstruktur 15. Hierzu wird durch photolithographische Verfahren zunächst eine Ätzmaske für die Grabenanordnung 16 hergestellt, die schließlich die Gestalt der Funktionsstruktur 15 bestimmt. Dann wird die Grabenstruktur 16 in einem Prozessschritt des Trockenätzens mit hohem Aspektverhältnis herausgeätzt und schließlich die Seitenwände der Grabenanordnung hinsichtlich des folgenden Ätzschrittes passiviert. Im Anschluss an die Passivierung der Seitenwände wird die Ätzmaske am Boden der Grabenanordnung selektiv wieder geöffnet. In dem sich anschließenden anisotropen Ätzschritt, dem sogenannten Release Etch, wird die Funktionsstruktur derart unterätzt, dass sie schließlich nur noch mit der Isolationsstruktur mit dem Substrat verbunden ist. Die Figur 7 zeigt Anordnung nach dem Release Etch, insbesondere die Anbindung der Funktionsstruktur an die Isolationsstruktur. Die Figur 8 zeigt die Anordnung der Figur 7 entlang der Schnittlinie 8-8 im Querschnitt.

Die Figur 9 zeigt die elektrische Kontaktierung einer einzelnen Funktionsstruktur 15 durch eine über die Isolationsstruktur 20 führende Leiterbahn 18. Die metallischen Leiterbahnen 18 inklusive Kontaktlöcher 19 werden anhand von in der IC-Technologie üblichen Verfahren, gegebenenfalls auch in 2-Lagen-Technik, hergestellt. Die Definition und Strukturierung der Leiterbahnen 18 erfolgt vorzugsweise noch vor dem Maskieren der Funktionsstrukturen 15.

Die Figur 10 zeigt als spezielles Ausführungsbeispiel einen Beschleunigungssensor mit einer differentiellen Kondensatorstruktur. Sowohl die Verankerung der beiden Federn, mit denen die bewegliche Struktur am Substrat aufgehängt ist, als auch die alternierend kontaktierten kapazitiven Finger sind mit einer entsprechenden Isolationsstruktur, die nach dem Verfahren gemäß der Erfindung hergestellt wurde, mit dem Substrat mechanisch verbunden. Die Aufhängekante der kapazitiven Finger ist über eine große Breite durchgehend isoliert. Hierzu wurden im ersten Schritt des beschriebenen Verfahrens eine kontinuierliche Anordnung von Trenchgräben 12 mit dazwischenliegenden Siliziumstegen angelegt. So kann eine durchgehende, isolierende Oxidstruktur 14 über vergleichsweise lange Wegstrecken erzeugt werden.

Nachfolgend ist der Ablauf des Verfahren nochmals kurz zusammengefasst:

Herstellung der Trenchgräben (Fig. 1,2):
- dazu lithografische Definition einer Ätzmaske (Fotolack oder SiO₂),
- Trockenätzen der Gräben mit hohem Aspektverhältnis, typische Tiefe ca. 10-30 µm,
- evt. entfernen der Ätzmaske (insbesondere von Fotolack).

Umwandlung der Zwischenstege in SiO₂ durch thermische Oxidation (Fig. 3-6):
- typische Prozessbedingungen ca. 1100 - 1200 °C bei Feuchtoxidation (H₂O),
- eventuell SiO₂ nass oder trocken entfernen und Oxidation wiederholen.

Herstellung der gewünschten mechanischen Funktionsstruktur sowie der elektrischen Kontaktierung:
- Metallische Leiterbahnen inkl. Kontaktlöcher nach in der IC-Technologie üblichen Verfahren, auch 2-Lagen-Technik (Fig. 9,10)
- Trockenätzen der Funktionsstruktur: Lithografie, Ätzen der Grabenstruktur, Seitenwandpassivierung, selektives Öffnen der Ätzmaske am Boden der Grabenstruktur, Release-Ätzschritt (frei ätzen) (Fig. 7,8)

Die Erfindung ermöglicht wesentliche Verbesserungen in der Herstellung von mikromechanischen Sensoren in einer Oberflächentechnologie auf der Basis von einkristallinem Silizium. In dieser Technologie können vor allem Inertialsensoren für Beschleunigung und Drehrate hergestellt werden. Insbesondere dient die Erfindung der kostengünstigen Herstellung von Beschleunigungssensoren für die Airbag-Anwendung in Kraftfahrzeugen.

## Patentansprüche

1. Verfahren zum Herstellen von Isolationsstrukturen mit folgenden Verfahrensschritten:
• Bereitstellen eines Halbleitersubstrates (11),
• Herstellen von mindestens zwei, voneinander beabstandeten Trenchgräben (12) im Halbleitersubstrat (11) mit mindestens einem zwischen den Trenchgräben (12) liegenden Steg (13),
• Umwandeln des Substratmaterials im Bereich der Trenchgräben (12) in ein elektrisch isolierendes Material (14) bis der dazwischenliegende Steg bzw. die dazwischenliegenden Stege (13) vollständig umgewandelt sind,
• Herstellen einer Funktionsstruktur (15) im Substratmaterial, die ausschließlich über das an den Trenchgräben gebildeten umgewandelten Substratmaterial mit dem Substrat mechanisch verbunden ist.

2. Verfahren nach Patentanspruch 1, **gekennzeichnet durch** die Verwendung von Silizium als Halbleitersubstrat.

3. Verfahren nach Patentanspruch 2, **dadurch gekennzeichnet, dass** das Umwandeln des Substratmaterials durch thermische Oxidation erfolgt.

4. Verfahren nach einem der Patentansprüche 1 bis 3, **dadurch gekennzeichnet, dass** durch eine kontinuierliche Anordnung von Trenchgräben (12) und dazwischenliegenden Stege (13) eine durchgehende isolierende Oxidstruktur (14) über längere Wegstrecken erzeugt wird.

5. Verfahren nach einem der Patentansprüche 1 bis 4, **dadurch gekennzeichnet, dass** bei größeren Breiten der Stege (13) der Verfahrensschritt der Umwandlung mehrstufig ausgeführt wird.

6. Verfahren nach Patentanspruch 5, **dadurch gekennzeichnet, dass** nach einem ersten Verfahrensschritt der Umwandlung, das so entstandene umgewandelte Material entfernt wird und anschließend in ein zweiten Verfahrensschritt der Umwandlung das verbliebene Material umgewandelt wird.

## Claims

1. A method for manufacturing isolation structures with the following procedural stages:
• provision of a semi-conductor substrate (11);
• production of at least two mutually spaced trenches (12) in the semi-conductor substrate (11) with at least one section (13) lying between the trenches (12);
• conversion of the substrate material in the region of the trenches (12) into an electrically insolating material (14), until the section or sections (13) lying in between is/are fully converted;
• production of a function structure (15) in the substrate material, which is connected mechanically to the substrate solely via the converted substrate material formed on the trenches.

2. A method according to patent claim 1, **characterised by** the use of silicon as a semi-conductor substrate.

3. A method according to patent claim 2, **characterised in that** the substrate material is converted via thermal oxidation.

4. A method according to any one of patent claims 1 to 3, **characterised in that** a continuous insolating oxide structure (14) is created over long distances via a continuous arrangement of trenches (12) and sections (13) lying between them.

5. A method according to any one of patent claims 1 to 4, **characterised in that** with larger widths of the sections (13), the procedural conversion stage is completed in several steps.

6. A method according to patent claim 5, **characterised in that** according to a first procedural conversion stage, the converted material thus created is removed, and the remaining material is then converted in a second procedural conversion stage.

## Revendications

1. Procédé pour la fabrication de structures isolantes avec les étapes de procédés suivantes :
• préparation d'un substrat de semi-conducteur (11),
• fabrication d'au moins deux tranchées (12) écartées l'une de l'autre dans le substrat de semi-conducteur (11) avec au moins une barrette (13) placée entre les tranchées (12),
• transformation du matériau de substrat dans la zone des tranchées (12) en un matériau électriquement isolant (14) jusqu'à ce que la barrette intermédiaire ou encore les barrettes intermédiaires (13) soient entièrement transformées,
• fabrication d'une structure de fonction (15) dans le substrat de matériau, laquelle est reliée mécaniquement au substrat exclusivement par le matériau de substrat transformé formé sur les tranchées.

2. Procédé selon la revendication 1, **caractérisé par** l'emploi de silicium comme substrat de semi-conducteur.

3. Procédé selon la revendication 2, **caractérisé en ce que** la transformation de substrat de matériau a lieu par oxydation thermique.

4. Procédé selon l'une des revendications 1 à 3, **caractérisé en ce que**, par une disposition continue de tranchées (12) et de barrettes intermédiaires (13), une structure d'oxydation (14) est produite sur des distances importantes.

5. Procédé selon l'une des revendications 1 à 4, **caractérisé en ce que**, pour des barrettes (13) de largeur plus importante, l'étape de procédé de transformation est exécutée en plusieurs étapes.

6. Procédé selon la revendication 5, **caractérisé en ce que**, après une première étape de procédé de transformation, le matériau transformé ainsi produit est ôté et ensuite le matériau restant est transformé au cours d'une deuxième étape de procédé de transformation.
